# FASCICULE DE BREVET EUROPEEN

(11) **EP 2 750 204 B1**
(45) Date de publication et mention de la délivrance du brevet: **06.03.2019**
(21) Numéro de dépôt: 13199122.6
(22) Date de dépôt: 20.12.2013
(51) Int. Cl.: H01L 33/00, H01L 33/06

(54) **Procédé de fabrication d'une diode électroluminescente comprenant une couche d'AlGaN hétérogène**
Herstellungsverfahren einer Leuchtdiode, die über eine heterogene AlGaN-Schicht verfügt
Method for manufacturing a light-emitting diode having a heterogeneous AlGaN layer

(30) Priorité: 26.12.2012 FR 1262794
(43) Date de publication de la demande: 02.07.2014
(73) Titulaire: COMMISSARIAT À L'ÉNERGIE ATOMIQUE ET AUX ÉNERGIES ALTERNATIVES, 75015 Paris (FR)
(72) Inventeur: Daudin, Bruno, 38700 LA TRONCHE (FR)
(74) Mandataire: Novaimo

(56) Documents cités:
- US-A1- 2003 094 618
- US-B1- 7 498 182

## Description

### Domaine technique de l'invention

L'invention concerne le domaine de la microélectronique et plus particulièrement des diodes électroluminescentes.

L'invention a pour objet plus particulièrement un procédé de fabrication d'une diode.

### État de la technique

Il est connu de fabriquer des diodes électroluminescentes à base d'un empilement de couches comportant du nitrure d'aluminium et de gallium.

Il est actuellement admis que les diodes électroluminescentes à base de nitrure d'aluminium et de gallium présentent une très mauvaise efficacité, de l'ordre de 5 %, cette mauvaise efficacité étant à comparer aux 80% d'efficacité des meilleures diodes électroluminescentes dans le spectre visible.

Les documents US7498182 et US2003/094618 concernent des méthodes connues et différentes de la présente invention de fabrication de diodes électroluminescentes à base d'un empilement de couches comportant du nitrure d'aluminium et de gallium.

### Objet de l'invention

Le but de la présente invention est de proposer une solution permettant d'améliorer le rendement des diodes électroluminescentes à base de nitrure d'aluminium et de gallium.

On tend vers ce but en ce que le procédé de fabrication d'une diode électroluminescente comporte les étapes suivantes : la formation d'un empilement de couches destiné à émettre de la lumière comprenant des première, deuxième, et troisième couches de nitrure d'aluminium et de gallium, ladite deuxième couche, disposée entre les première et troisième couches, ayant une composition de nitrure d'aluminium et de gallium différente de celle des première et troisième couches ; et la réalisation d'une démixtion de la deuxième couche de nitrure d'aluminium et de gallium mise en oeuvre après formation de ladite deuxième couche.

Avantageusement, les première et troisième couches sont déposées lors de la formation de l'empilement de sorte à former des couches de nitrure d'aluminium et de gallium de composition Al_{y}Ga_{1-y}N et la deuxième couche est déposée lors de la formation de l'empilement de sorte à former une couche de nitrure d'aluminium et de gallium de composition AlₓGa₁₋ₓN, avec x différent de y et de préférence y strictement supérieur à x.

De préférence, x est compris entre 0,1 et 0,8 bornes inclues et 0,01 ≤ y-x ≤ 0,1 et avantageusement y = x + 0,05.

Selon un mode d'exécution, l'étape de réalisation de la démixtion est configurée de sorte à former une hétérostructure comportant une matrice de composition Alₓ₁Ga₁₋ₓ₁N qui enrobe des îlots de composition Alₓ₂Ga₁₋ₓ₂N avec x1 différent de x2.

De préférence, x2 est strictement inférieur à y, et de préférence égal à y-0,05.

Selon un premier exemple, l'étape de démixtion est réalisée après dépôt de la deuxième couche sur la première couche mais avant dépôt de la troisième couche sur la deuxième couche.
Selon un deuxième exemple, l'étape de démixtion est réalisée après l'étape de formation de l'empilement, notamment en utilisant un laser ajusté de sorte que sa lumière soit absorbée par la deuxième couche mais pas par les première et troisième couches.
L'invention est aussi relative à une diode électroluminescente obtenue par le procédé tel que décrit ou plus généralement à une diode électroluminescente comportant un empilement émissif comprenant des première, deuxième, et troisième couches de nitrure d'aluminium et de gallium, ladite deuxième couche étant une hétérostructure, disposée entre les première et troisième couches, comportant une matrice selon une première composition de nitrure d'aluminium et de gallium qui enrobe des îlots selon une deuxième composition de nitrure d'aluminium et de gallium différente de la première composition.

Dans la diode, les première et troisième couches sont avantageusement de composition Al_{y}Ga_{1-y}N, de préférence y étant compris entre 0,15 et 0,85 bornes inclues, et la matrice est de composition Alₓ₁Ga₁₋ₓ₁N et les îlots de composition Alₓ₂Ga₁₋ₓ₂N avec x1 différent de x2, de préférence x2 étant inférieur à y.
L'invention est aussi relative à un panneau lumineux comprenant au moins une diode électroluminescence telle que décrite.

### Description sommaire des dessins

D'autres avantages et caractéristiques ressortiront plus clairement de la description qui va suivre de modes particuliers de réalisation de l'invention donnés à titre d'exemples non limitatifs et représentés sur les dessins annexés, dans lesquels :
- la figure 1 est une vue en coupe d'un empilement avant démixtion,
- la figure 2 est une vue en coupe d'un empilement après démixtion.
- La figure 3 illustre une vue en coupe d'un empilement comprenant plusieurs couches ayant subies une démixtion,
- La figure 4 illustre une réalisation particulière d'une diode.

### Description de modes préférentiels de l'invention

Le procédé et la diode décrits ci-après diffèrent de l'art antérieur notamment en ce qu'un traitement particulier est appliqué à au moins une couche de nitrure d'aluminium et de gallium de sorte à diminuer la recombinaison de porteurs non radiative sur les défauts structuraux tels que les dislocations traversantes et à augmenter la recombinaison radiative dans des zones nanométriques où sont piégés ces mêmes porteurs.

En fait, lors de la formation d'un empilement de couches à base de nitrure d'aluminium et de galium, il s'avère que certaines zones peuvent présenter des défauts. Ces défauts sont supposés être une source importante de recombinaisons non radiative. Il en résulte donc une possibilité de favoriser une forte recombinaison radiative en protégeant les porteurs de leur environnement défectueux par la présence de zones idoines dans une structure de diode.

Néanmoins, il s'avère que le nitrure d'aluminium et de gallium est un système suffisamment homogène dans toute la gamme de composition pour ne pas permettre la localisation spontanée des porteurs dans des zones exemptes de défauts structuraux. Il n'est donc pas a priori possible de tirer profit, par exemple, de la présence de zones à plus forte composition de Ga dans une même couche d'AlGaN, ce qui pourrait permettre de limiter les effets préjudiciables à une grande quantité de défauts structuraux.

Pour répondre à cette problématique, il a été réalisé un procédé spécifique de fabrication d'au moins une diode électroluminescente.

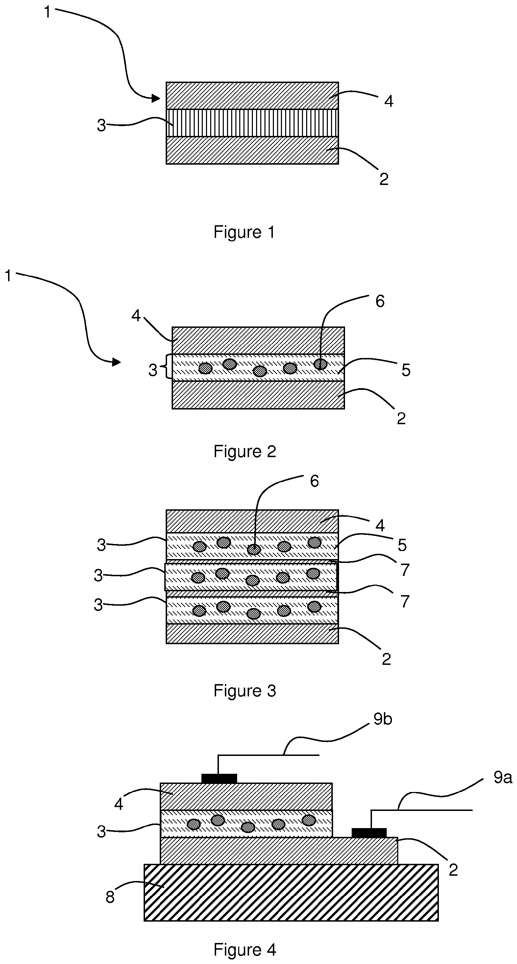

Comme illustré aux figures 1 et 2, un procédé de fabrication d'une diode électroluminescente comporte une étape de formation d'un empilement 1 de couches (figure 1) destiné à émettre de la lumière. Typiquement, au moins une couche de l'empilement 1 est source de recombinaisons permettant de générer la lumière de sorte à l'émettre. Cet empilement 1 comprend des première 2, deuxième 3, et troisième 4 couches de nitrure d'aluminium et de gallium. La deuxième couche 3 est disposée entre les première et troisième couches 2, 4. Par ailleurs, cette deuxième couche 3 a une composition de nitrure d'aluminium et de gallium différente de celle des première 2 et troisième 4 couches. L'empilement 1 peut comprendre successivement les première 2, deuxième 3, et troisième 4 couches de nitrure d'aluminium et de gallium, autrement dit ces couches sont en contact direct deux à deux, mais d'autres couches peuvent alternativement être intercalées pour améliorer l'efficacité globale de la diode.

Avantageusement dans le cadre de la diode, les première et troisième couches 2 et 4 sont dopées respectivement de type p et de type n afin de former des barrières de potentiel pour empêcher les porteurs de s'échapper de la deuxième couche 3, qui forme alors une couche active de la diode, une fois qu'ils ont été collectés. De préférence, la deuxième couche 3 présente une composition en aluminium moins élevée que les première et troisième couches 2, 4. La deuxième couche 3 est aussi appelée puits de potentiel.

Selon une variante illustrée à la figure 3, il est réalisé entre les première et troisième couches 2, 4 plusieurs deuxièmes couches 3 séparées deux à deux par une couche barrière 7. Ceci a pour effet d'améliorer l'efficacité de la diode. De préférence, la diode comprend entre trois et cinq deuxièmes couches dont les deux plus éloignées sont de préférence en contact direct respectivement avec la première couche 2 et la troisième couche 4. Chaque couche barrière 7 est en général de même composition que les première et troisième couches 2, 3 à la différence qu'elles ne sont pas dopées.

De préférence, les première et troisième couches 2, 4 sont de composition de nitrure d'aluminium et de galium identique (c'est-à-dire présentant la même homogénéité).

Enfin, le procédé comporte une étape de réalisation d'une démixtion, notamment d'origine thermique, de la deuxième couche 3 de nitrure d'aluminium et de gallium. Par origine thermique, on entend un apport volontaire de calories de sorte à modifier la structure d'une couche. Cette étape a pour effet de modifier la structure homogène de la deuxième couche 3 en une structure hétérogène. Cette structure hétérogène comporte alors préférentiellement une matrice 5 en nitrure d'aluminium et de gallium qui enrobe des îlots 6 en nitrure d'aluminium et de gallium, les îlots étant de composition différente de la matrice 5 (figures 2 et 3). Les îlots 6 ont pour but de former des zones préférentielles de recombinaison des porteurs de sorte à améliorer le rendement de la diode électroluminescente permettant ainsi de pallier les recombinaisons non émettrice dans certains défauts de structure. De manière inattendue, il est possible de réaliser une démixtion permettant une séparation de phase de l'alliage de nitrure d'aluminium et de gallium qui constituait initialement la deuxième couche 3 de sorte à former une matrice 5 plus riche en aluminium que les îlots 6 (la matrice comporte plus d'aluminium que les îlots), et des îlots 6 plus riches en gallium que la matrice 5 (la matrice comporte alors moins de gallium que les îlots).

Autrement dit, un îlot 6 délimite un volume formé au moins en partie ou en totalité par une composition donnée de nitrure d'aluminium et de gallium, le volume étant enrobé totalement par un matériau formé d'une composition différente de nitrure d'aluminium et de gallium et formant la matrice 5.

De préférence, les îlots et les différentes couches de l'empilement sont cristallins et présentent la même orientation cristallographique. Autrement dit, la matrice 5 et les îlots 6 peuvent être cristallins et présenter la même orientation cristallographique.

L'étape de réalisation de la démixtion est mise en oeuvre avantageusement après formation de ladite deuxième couche 3, notamment après le dépôt de la deuxième couche 3. Par « après formation de ladite deuxième couche 3 », on peut entendre directement et consécutivement à la formation de ladite deuxième couche, ou encore après formation de l'empilement, etc. Autrement dit, l'étape de démixtion est réalisée par modification de la deuxième couche 3 formée.

De préférence, les première et troisième couches 2, 4 sont déposées lors de la formation de l'empilement 1 de sorte à former des couches de nitrure d'aluminium et de gallium de composition Al_{y}Ga_{1-y}N et la deuxième couche 3 est déposée lors de la formation de l'empilement 1 de sorte à former une couche de nitrure d'aluminium et de gallium de composition AlₓGa₁₋ₓN avec x différent de y, et de préférence x strictement inférieur à y. En fait, la hauteur de la barrière (couches 2 et 4) varie avec la concentration en aluminium dans la composition de la couche concernée. C'est notamment pour cela que y>x. Ainsi, les porteurs ne peuvent pas s'échapper notamment à la température ambiante où l'excitation thermique leur donne une énergie qui pourrait leur suffire à s'échapper.

De manière avantageuse, x est compris entre 0,1 et 0,8 bornes inclues et 0,01≤y-x≤0,1 et avantageusement y = x + 0,05. Ces contraintes permettent de maximiser le gain de rendement de la future diode électroluminescente.

On comprend de ce qui a été dit précédemment que l'étape de réalisation de la démixtion peut être configurée de sorte à former une hétérostructure comportant une matrice 5 de composition Alₓ₁Ga₁₋ₓ₁N qui enrobe des îlots 6 de composition Alₓ₂Ga₁₋ₓ₂N avec x1 différent de x2, et notamment x2 est strictement inférieur à x1. En fait, par hétérostructure d'une couche, on entend que la couche comporte des zones de compositions différentes, c'est-à-dire des zones de mêmes matériaux mais dans des rapports/quantités différents.
De préférence, x, y, x1 et x2 sont des entiers positifs strictement supérieurs à 0.
De préférence x2 est strictement inférieur à y, et avantageusement 0,01≤y-x2≤0,1 de préférence égal à y-0,05. Ceci permettant comme évoqué précédemment de maximiser les rendements de la future diode électroluminescente tout en maintenant la composition des barrières la plus basse possible pour faciliter la réalisation des dopages électriques de type n et de type p.
Selon un mode d'exécution, l'étape de démixtion est réalisée après dépôt de la deuxième couche 3 sur la première couche 2 mais avant dépôt de la troisième couche 4 sur la deuxième couche 3. Pour cela, l'étape de démixtion peut être un recuit de la deuxième couche 3 après sa formation. Le recuit peut être mis en oeuvre par une température supérieure à 1000°C. De manière avantageuse, le recuit est fait sous flux d'azote et à pression atmosphérique. Un tel recuit permet d'induire une séparation de phase dans l'AlₓGa₁₋ₓN (deuxième couche 3) résultant de la décomposition de l'AlₓGa₁₋ₓN en une nouvelle hétérostructure constituée d'Alₓ₁Ga₁₋ₓ₁ N qui enrobe des îlots 6 d' Alₓ₂Ga₁₋ₓ₂ N. Le recuit est avantageusement réalisé en tirant parti du fait que l'Al_{y}Ga_{1-y}N est thermiquement plus stable que l'AlₓGa₁₋ₓN, autrement dit le recuit ne porte pas préjudice à la composition de la première couche 2. Selon un test effectué en laboratoire, un recuit à 1700°C a permis de transformer la deuxième couche 3 en un ensemble constitué de cristallites riches en Ga au sein d'une matrice riche en Al. Ces résultats démontrent une démixtion inattendue de l'alliage AlGaN à 50% de composition moyenne en une phase riche-Ga et en une phase riche-AI. Par ailleurs, les îlots 6 délimitent chacun une zone suffisamment petite pour permettre aux porteurs d'y être confinés sans interaction avec les défauts cristallins étendus (dislocations). Ainsi, un tel procédé permet l'augmentation de l'efficacité de la recombinaison radiative en évitant que les porteurs subissent une recombinaison non radiative sur les dislocations en question.

Selon un autre mode d'exécution, l'étape de démixtion est réalisée après l'étape de formation de l'empilement 1, notamment en utilisant un laser ajusté de sorte que sa lumière soit absorbée par la deuxième couche 3 mais pas par les première 2 et troisième 4 couches.

Par exemple, lorsque les première et troisième couches 2 et 4 présentent 30% d'aluminium, et que la deuxième couche 3 présente 40% d'aluminium, il est possible de réaliser la démixtion de la deuxième couche 3 en utilisant un laser (par exemple un laser accordable de puissance) dont la longueur d'onde sera réglée à une valeur supérieure à la longueur d'onde minimale absorbée par la deuxième couche 3 (ici 280nm) mais inférieure aux longueurs d'onde absorbées par les première et troisième couches (ici 305nm) : de cette façon la longueur d'onde du laser sera absorbée uniquement par la deuxième couche qui s'échauffera.

Avantageusement, la première couche 2 présente une épaisseur de l'ordre du µm alors que la troisième couche 4 est plutôt de l'ordre de quelques centaines de nanomètre car le dopage p est plus difficile réaliser (afin de conserver une résistance électrique faible, il est préférable d'avoir des épaisseurs faibles). Enfin, la deuxième couche 3 présente une épaisseur de l'ordre de quelques dizaines de nanomètres pour accueillir des îlots de quelques nanomètres.

Il est à noter que x1 et x2 peuvent prendre différentes valeurs dépendant de la température et du temps de recuit (que cela soit une simple montée en température de la deuxième couche 3 dans une enceinte contrôlée ou par l'utilisation du laser). Par ailleurs, en combinaison avec tout ce qui a été dit précédemment, x1 peut notamment devenir supérieur à y. En revanche, l'ajustement du processus de recuit, c'est à dire l'étape de démixtion, est avantageusement tel que x2 reste strictement inférieur à y, et préférentiellement y-0,1≤x2≤y-0,01 et de préférence égal à y-0.05.

Dans l'hétérostructure, ce sont les îlots qui sont dits « actifs ». C'est eux qui doivent vérifier la relation entre x et y. La matrice ne participe alors pas au fonctionnement.

Le procédé peut être élargi à la fabrication d'une pluralité de diodes électroluminescentes à partir d'un même substrat de support, les empilements de différentes diodes pouvant alors être réalisés de manière simultanée.

Bien entendu, l'invention est aussi relative à une diode électroluminescente obtenue par le procédé tel que décrit. Une telle diode électroluminescente ne sera pas décrite en détails car, outre la composition spécifique de la deuxième couche 3 notamment obtenue par le procédé tel que décrit, les autres éléments constitutifs de la diode électroluminescente sont communs de l'homme du métier.

Typiquement la diode peut être réalisée sur un substrat de support 8 de sorte que les contacts électriques 9a, 9b soient repris des première et troisième couches 2, 4 comme illustré à la figure 4.

Autrement dit, pour généraliser, la diode électroluminescente peut comporter un empilement émissif comprenant des première, deuxième, et troisième couches 2, 3, 4 de nitrure d'aluminium et de gallium, de sorte que la deuxième couche 3 est disposée entre les première et troisième couches 2, 4. La deuxième couche 3 présente alors une hétérostructure comportant une matrice 5 selon une première composition de nitrure d'aluminium et de gallium qui enrobe des îlots 6 selon une deuxième composition de nitrure d'aluminium et de gallium différente de la première composition. Notamment, la première composition est plus riche en aluminium que la deuxième composition et la deuxième composition est plus riche en gallium que la première composition.

Avantageusement, dans la diode électroluminescente, les première et troisième couches 2, 4 sont de composition Al_{y}Ga_{1-y}N, de préférence y étant compris entre 0,15 et 0,85 bornes inclues, la matrice est de composition Alₓ₁Ga₁₋ₓ₁N et les îlots de composition Alₓ₂Ga₁₋ₓ₂N avec x1 différent de x2, de préférence x2 étant strictement inférieur à y, et de préférence x1 étant strictement supérieur à x2.

L'invention est aussi relative à un panneau lumineux comprenant au moins une diode électroluminescence telle que décrite selon les différentes mises en oeuvres ci-dessus.

En fait, dans une diode électroluminescente, l'utilisation du nitrure d'aluminium et de gallium est avantageuse car il permet à ladite diode d'émettre une lumière de rayonnements ultraviolets.

## Revendications

1. Procédé de fabrication d'une diode électroluminescente comportant une étape de formation d'un empilement (1) de couches destiné à émettre de la lumière comprenant des première (2), deuxième (3), et troisième (4) couches de nitrure d'aluminium et de gallium, ladite deuxième couche (3), disposée entre les première et troisième couches (2, 4), ayant une composition de nitrure d'aluminium et de gallium différente de celle des première et troisième couches (2, 4), **caractérisé en ce qu'**il comporte une étape de réalisation d'une démixtion de la deuxième couche (3) de nitrure d'aluminium et de gallium mise en oeuvre après formation de ladite deuxième couche (3).

2. Procédé selon la revendication 1, **caractérisé en ce que** les première et troisième couches (2, 4) sont déposées lors de la formation de l'empilement (1) de sorte à former des couches de nitrure d'aluminium et de gallium de composition Al_{y}Ga_{1-y}N et **en ce que** la deuxième couche (3) est déposée lors de la formation de l'empilement (1) de sorte à former une couche de nitrure d'aluminium et de gallium de composition AlₓGa₁₋ₓN, avec x différent de y et de préférence y strictement supérieur à x.

3. Procédé selon la revendication précédente, **caractérisé en ce que** x est compris entre 0,1 et 0,8 bornes inclues et **en ce que** 0,01 ≤ y-x ≤ 0,1 et avantageusement y = x + 0,05.

4. Procédé selon l'une quelconque des revendications précédentes, **caractérisé en ce que** l'étape de réalisation de la démixtion est configurée de sorte à former une hétérostructure comportant une matrice (5) de composition Alₓ₁Ga₁₋ₓ₁N qui enrobe des îlots (6) de composition Alₓ₂Ga₁₋ₓ₂N avec x1 différent de x2.

5. Procédé selon la revendication précédente et l'une des revendications 2 ou 3, **caractérisé en ce que** x2 est strictement inférieur à y, et de préférence égal à y-0,05.

6. Procédé selon l'une quelconque des revendications précédentes, **caractérisé en ce que** l'étape de démixtion est réalisée après dépôt de la deuxième couche (3) sur la première couche (2) mais avant dépôt de la troisième couche (4) sur la deuxième couche (3).

7. Procédé selon l'une quelconque des revendications 1 à 6, **caractérisé en ce que** l'étape de démixtion est réalisée après l'étape de formation de l'empilement (1), notamment en utilisant un laser ajusté de sorte que sa lumière soit absorbée par la deuxième couche (3) mais pas par les première et troisième couches (2,4).

8. Diode électroluminescente obtenue par le procédé selon l'une des revendications 1 à 7.

9. Diode électroluminescente selon la revendication 8, **caractérisée en ce qu'**elle comporte un empilement émissif comprenant des première, deuxième, et troisième couches (2 ,3, 4) de nitrure d'aluminium et de gallium, ladite deuxième couche (3) étant une hétérostructure, disposée entre les première et troisième couches (2, 4), comportant une matrice (5) selon une première composition de nitrure d'aluminium et de gallium qui enrobe des îlots (6) selon une deuxième composition de nitrure d'aluminium et de gallium différente de la première composition.

10. Diode selon la revendication précédente, **caractérisée en ce que** les première et troisième couches (2, 4) sont de composition Al_{y}Ga_{1-y}N, de préférence y étant compris entre 0,15 et 0,85 bornes inclues, et **en ce que** la matrice (5) est de composition Alₓ₁Ga₁₋ₓ₁N et les îlots (6) de composition Alₓ₂Ga₁₋ₓ₂N avec x1 différent de x2, de préférence x2 étant inférieur à y.

11. Panneau lumineux comprenant au moins une diode électroluminescence selon l'une des revendications 8 à 10.

## Patentansprüche

1. Verfahren zur Herstellung einer Leuchtdiode, umfassend einen Schritt der Bildung eines zur Emission von Licht vorgesehenen Schichtenstapels (1) mit einer ersten (2), zweiten (3) und dritten (4) Schicht aus Aluminiumgalliumnitrid, wobei die zweite Schicht (3), die zwischen der ersten und dritten Schicht (2, 4) angeordnet ist, eine andere Aluminiumgalliumnitrid-Zusammensetzung aufweist als die erste und dritte Schicht (2, 4), **dadurch gekennzeichnet, dass** es einen Schritt der Durchführung einer Entmischung der zweiten Schicht (3) aus Aluminiumgalliumnitrid umfasst, der nach der Bildung der zweiten Schicht (3) durchgeführt wird.

2. Verfahren nach Anspruch 1, **dadurch gekennzeichnet, dass** die erste und dritte Schicht (2, 4) bei der Bildung des Schichtenstapels (1) so abgeschieden werden, dass Schichten aus Aluminiumgalliumnitrid mit der Zusammensetzung Al_{y}Ga_{1-y}N gebildet werden, und dass die zweite Schicht (3) bei der Bildung des Schichtenstapels (1) so abgeschieden wird, dass eine Schicht aus Aluminiumgalliumnitrid mit der Zusammensetzung AlₓGa₁₋ₓN gebildet wird, wobei x von y verschieden ist und vorzugsweise y streng größer als x ist.

3. Verfahren nach dem vorhergehenden Anspruch, **dadurch gekennzeichnet, dass** x zwischen 0,1 und 0,8 einschließlich der Grenzen liegt und dass 0,01 ≤ y-x ≤ 0,1 und vorteilhafterweise y = x + 0,05.

4. Verfahren nach einem der vorhergehenden Ansprüche, **dadurch gekennzeichnet, dass** der Schritt der Durchführung der Entmischung so ausgestaltet ist, dass eine Heterostruktur mit einer Matrix (5) mit der Zusammensetzung Alₓ₁Ga₁₋ₓ₁N gebildet wird, die Inselchen (6) mit der Zusammensetzung Alₓ₂Ga₁₋ₓ₂N umhüllt, wobei x1 von x2 verschieden ist.

5. Verfahren nach dem vorhergehenden Anspruch und einem der Ansprüche 2 oder 3, **dadurch gekennzeichnet, dass** x2 streng kleiner als y und vorzugsweise gleich y-0,05 ist.

6. Verfahren nach einem der vorhergehenden Ansprüche, **dadurch gekennzeichnet, dass** der Entmischungsschritt nach der Abscheidung der zweiten Schicht (3) auf der ersten Schicht (2), aber vor der Abscheidung der dritten Schicht (4) auf der zweiten Schicht (3) durchgeführt wird.

7. Verfahren nach einem der Ansprüche 1 bis 6, **dadurch gekennzeichnet, dass** der Entmischungsschritt nach dem Schritt der Bildung des Stapels (1) durchgeführt wird, insbesondere unter Verwendung eines Lasers, der so eingestellt wird, dass ein Licht von der zweiten Schicht (3), aber nicht von der ersten und dritten Schicht (2, 4) absorbiert wird.

8. Leuchtdiode, erhalten durch das Verfahren nach einem der Ansprüche 1 bis 7.

9. Leuchtdiode nach Anspruch 8, **dadurch gekennzeichnet, dass** sie einen Emissionsstapel mit einer ersten, zweiten und dritten Schicht (2, 3, 4) aus Aluminiumgalliumnitrid umfasst, wobei es sich bei der zweiten Schicht (3) um eine zwischen der ersten und dritten Schicht (2, 4) angeordnete Heterostruktur mit einer Matrix (5) gemäß einer ersten Aluminiumgalliumnitrid-Zusammensetzung, die Inselchen (6) gemäß einer zweiten Aluminiumgalliumnitrid-Zusammensetzung, die von der ersten Zusammensetzung verschieden ist, umhüllt, handelt.

10. Diode nach dem vorhergehenden Anspruch, **dadurch gekennzeichnet, dass** die erste und dritte Schicht (2, 4) die Zusammensetzung Al_{y}Ga_{1-y}N aufweisen, wobei vorzugsweise y zwischen 0,15 und 0,85 einschließlich der Grenzen liegt, und dass die Matrix (5) die Zusammensetzung Alₓ₁Ga₁₋ₓ₁N aufweist und die Inselchen (6) die Zusammensetzung Alₓ₂Ga₁₋ₓ₂N aufweisen, wobei x1 von x2 verschieden ist und vorzugsweise x2 kleiner als y ist.

11. Leuchtfeld, umfassend mindestens eine Leuchtdiode nach einem der Ansprüche 8 bis 10.

## Claims

1. Process for the manufacture of a light-emitting diode, comprising the formation of a stack (1) of layers intended to emit light comprising first (2), second (3) and third (4) layers of aluminium gallium nitride, the said second layer (3), positioned between the first and third layers (2, 4), having a different aluminium gallium nitride composition from that of the first and third layers (2, 4), **characterized in that** it comprises a step of implementation of a demixing of the second layer (3) of aluminium gallium nitride carried out after formation of the said second layer (3).

2. Process according to Claim 1, **characterized in that** the first and third layers (2, 4) are deposited during the formation of the stack (1) so as to form layers of aluminium gallium nitride having the composition Al_{y}Ga_{1-y}N and that the second layer (3) is deposited during the formation of the stack (1) so as to form a layer of aluminium gallium nitride having the composition AlₓGa₁₋ₓN, with x different from y and preferably y strictly greater than x.

3. Process according to the preceding claim, **characterized in that** x is between 0.1 and 0.8, limits included, and **in that** 0.01 ≤ y-x ≤ 0.1 and advantageously y = x + 0.05.

4. Process according to any one of the preceding claims, **characterized in that** the stage of implementation of the demixing is configured so as to form a heterostructure comprising a matrix (5) having the composition Alₓ₁Ga₁₋ₓ₁N which coats islets (6) having the composition Alₓ₂Ga₁₋ₓ₂N with x1 different from x2.

5. Process according to the preceding claim and one of Claims 2 or 3, **characterized in that** x2 is strictly less than y and preferably equal to y-0.05.

6. Process according to any one of the preceding claims, **characterized in that** the demixing stage is carried out after deposition of the second layer (3) on the first layer (2) but before deposition of the third layer (4) on the second layer (3).

7. Process according to any one of Claims 1 to 6, **characterized in that** the demixing stage is carried out after the stage of formation of the stack (1), in particular by using a laser adjusted so that its light is absorbed by the second layer (3) but not by the first and third layers (2, 4).

8. Light-emitting diode obtained by the process according to one of Claims 1 to 7.

9. Light-emitting diode according to claim 8, **characterized in that** it comprises an emissive stack comprising first, second and third layers (2, 3, 4) of aluminium gallium nitride, the said second layer (3) being a heterostructure, positioned between the first and third layers (2, 4), comprising a matrix (5) according to a first aluminium gallium nitride composition which coats islets (6) according to a second aluminium gallium nitride composition different from the first composition.

10. Diode according to the preceding claim, **characterized in that** the first and third layers (2, 4) have the composition Al_{y}Ga_{1-y}N, y preferably being between 0.15 and 0.85, limits included, and **in that** the matrix (5) has the composition Alₓ₁Ga₁₋ₓ₁N and the islets (6) have the composition Alₓ₂Ga₁₋ₓ₂N with x1 different from x2, x2 preferably being less than y.

11. Light panel comprising at least one light-emitting diode according to one of Claims 8 to 10.
